# EUROPÄISCHE PATENTANMELDUNG

(11) **EP 1 246 518 A2**
(43) Veröffentlichungstag der Anmeldung: **02.10.2002**
(21) Anmeldenummer: 02100263.9
(22) Anmeldetag: 15.03.2002
(51) Int. Cl.: H05K 13/00

(54) **Klemmeinrichtung für Leiterplatten und Verfahren zum Verwenden der Klemmeinrichtung**

(30) Priorität: 27.03.2001 DE 10114953
(71) Anmelder: SIEMENS AKTIENGESELLSCHAFT, 80333 München (DE)
(72) Erfinder: Raabe, Martin, 76646, Bruchsal (DE); Zoller, Marc, 76199, Karlsruhe (DE)

(57) **Zusammenfassung**

Klemmeinrichtung für Leiterplatten (100) und Verfahren zum Verwenden der Klemmeinrichtung, bei welcher Leiterplatten (100) zwischen einem Vorsprung (210-1), welcher an einer Seitenführung (200-1) für die Leiterplatten (100) angeordnet ist, und einem Träger (320) geklemmt werden. Mittels einem Wegaufnehmer wird der Abstand des Trägers (320)von dem Vorsprung (210-1) überwacht. Eine Regelvorrichtung ist vorgesehen und regelt den Abstand zwischen dem Träger (320) und dem Vorsprung (210-1) entsprechend der Dicke der Leiterplatten. Hierdurch ist ein schnelles und sicheres Klemmen der Leiterplatten (100) möglich.

## Beschreibung

Die Erfindung betrifft eine Klemmeinrichtung für Leiterplatten und ein Verfahren zum Verwenden der Klemmeinrichtung.

Herkömmlicherweise werden Leiterplatten in Bearbeitungseinrichtungen geklemmt, in dem sie beispielsweise mittels eines Federkammes gegen einen Anschlag gedrückt werden. Der Anschlag kann beispielsweise entlang einer Führungsschiene für die Leiterplatten ausgebildet sein. Mittels einer Transportvorrichtung können die Leiterplatten entlang der Führungsschiene transportiert werden. Beispielsweise ist aus der europäischen Patentanmeldung EP 0491539 A1 bekannt, Leiterplatten mittels Federelementen gegen einen Anschlag einer Führungsschiene für die Leiterplatten zu drücken.

Bei den herkömmlichen Klemmeinrichtungen ist jedoch eine relativ lange Wartezeit erforderlich, um sicherzustellen, dass das Klemmen der Leiterplatte sicher durchgeführt worden ist, ist, ehe mit der weiteren Bearbeitung der Leiterplatte nach dem Klemmen fortgesetzt werden kann. Außerdem besteht beim Klemmen einer Leiterplatte mittels eines Federkammes oder einer Feder, welche an einem Träger angeordnet ist, die Gefahr, dass das Klemmen fehlerhaft durchgeführt wird.

Klemmen mit einer Feder ist allenfalls geeignet, wenn nach unten auf einen unter der zu klemmenden Leiterplatte angeordneten Anschlag geklemmt werden soll. Beim Klemmen nach oben gegen einen über der zu klemmenden Leiterplatte angeordneten Anschlag wirkt jedoch die Gewichtskraft der Leiterplatte und der Feder der Klemmkraft entgegen. Hierdurch ist ein gleichmäßiges Klemmen nicht sichergestellt.

Andererseits hat ein Klemmen nach unten den Nachteil, dass bei unterschiedlich dicken zu klemmenden Leiterplatten die zu bearbeitenden Oberflächen der geklemmten Leiterplatten in unterschiedlicher Höhe zu liegen kommen. Dies bereitet Schwierigkeiten bei der Bearbeitung der Leiterplatten, z.B. beim Bestücken unterschiedlicher Leiterplatten mit Bauelementen, da hierbei die unterschiedlichen Höhen ausgeglichen werden müssen.

Der Erfindung liegt daher die Aufgabe zugrunde, eine Klemmeinrichtung für Leiterplatten und ein Verfahren zum Verwenden der Klemmeinrichtung anzugeben, mittels welchen das Klemmen von Leiterplatten schneller und sicherer gemacht wird.

Diese Aufgabe wird gelöst durch eine Klemmeinrichtung mit den Merkmalen nach Anspruch 1 sowie ein Verfahren zum Verwenden der Klemmeinrichtung mit den Merkmalen nach Anspruch 8. Bevorzugte Ausgestaltungen der Erfindung sind in den abhängigen Ansprüchen beansprucht.

Erfindungsgemäß wird eine Klemmeinrichtung geschaffen, mit welcher es möglich ist, während des Klemmens einer Leiterplatte an einen Vorsprung den Abstand zwischen dem Vorsprung und einem zum Klemmen verwendeten Träger mit Hilfe eines Wegaufnehmers zu überwachen. Die Leiterplatten sind dabei im wesentlichen parallel zu dem Träger angeordnet. Seitenführungen sind seitlich des Trägers und der Leiterplatten vorgesehen und dienen zum Führen der Leiterplatten entlang einer Transportrichtung. Entlang der Transportrichtung können die Leiterplatten beispielsweise mittels einer Transportvorrichtung, wie z. B. einem Transportband, in der Transportrichtung transportiert werden. An der Seitenführung ist ein Vorsprung ausgebildet, der sich über den Leiterplatten parallel zu der Bestückfläche der Leiterplatten erstreckt. Der Träger ist mit einem regelbaren Antrieb gekoppelt, mittels welchem der Träger auf den Vorsprung zu bewegbar ist. Hierdurch ist es möglich, die Leiterplatte zwischen dem Träger und dem Vorsprung festzulegen. Die Leiterplatte kann dabei an einer Seite geklemmt werden oder auch an mehreren Seiten, z. B. an zwei einander gegenüberliegenden Seiten. Erfindungsgemäß ist auch ein Wegaufnehmer vorgesehen, der mit einer Regelvorrichtung gekoppelt ist. Die Regelvorrichtung ist ebenfalls mit dem Antrieb gekoppelt.

Bei bekannter Dicke der Leiterplatte als Führungsgröße für die Regelvorrichtung und dem Abstand zwischen dem Träger und dem Vorsprung als Regelgröße der Regelvorrichtung ist es möglich, den Abstand des Trägers von dem Vorsprung entsprechend der Dicke der Leiterplatte zu regeln. Hierbei wird die Leiterplatte schnell und sicher geklemmt.

Um geringen Abweichungen in der Dicke der Leiterplatte zu begegnen, sieht eine Weiterbildung der Erfindung vor, dass nach dem Regeln des Abstands zwischen dem Träger und der Leiterplatte der Antrieb zum Verringern des Abstands steuerbar ist. Hierbei wird der Antrieb zum Verringern des Abstands zwischen dem Träger und dem Vorsprung angesteuert und gleichzeitig mittels der Regelvorrichtung und dem Wegaufnehmer überwacht, ob sich der Abstand verringert. Verringert sich der Abstand nicht mehr, ist das Klemmen abgeschlossen.

Zusätzlich kann eine Zeitverzögerung vorgesehen werden. Durch die Zeitverzögerung wird für eine vorbestimmte Zeitdauer abgewartet, nachdem keine Verringerung des Abstands mehr erfasst worden ist. Erst danach wird von der Regelvorrichtung ein Freigabesignal an eine Bearbeitungsvorrichtung ausgegeben. Hierdurch wird eine zusätzliche Sicherheit für das Klemmen der Leiterplatte vorgesehen.

Der Wegaufnehmer kann beispielsweise ein optischer Aufnehmer, ein induktiver Aufnehmer, ein magnetischer Aufnehmer, ein resistiver Aufnehmer und/oder ein inkrementaler Aufnehmer sein. Es kommt auch eine Kombination der unterschiedlichen Aufnehmer-Arten in Frage. Es ist auch möglich, einen Winkelaufnehmer zu verwenden, welcher über eine Welle und einen mit der Welle verbundenen Exzenter eine Linearbewegung aufnehmen kann. Das Verwenden eines Winkelaufnehmers bietet den Vorteil, dass der für den Aufnehmer erforderliche Bauraum sehr gering ist.

Nach einer weiteren Ausgestaltung der Erfindung kann der Träger zum Klemmen der Leiterplatte auch an einem Transportband angreifen, auf welchem die Leiterplatten zum Transportieren in der Transportrichtung angeordnet sind. Hierbei wird die Leiterplatte mittelbar geklemmt.

Beim mittelbaren Klemmen der Leiterplatte wird das Transportband zwischen der Leiterplatte und dem Träger geklemmt. Hierdurch wird der konstruktive Aufwand der Klemmeinrichtung verringert, da keine Umlenkung für das Transportband oder keine Unterbrechung des Transportbandes erforderlich sind, um ein wirksames Klemmen der Leiterplatte durchführen zu können.

Als Träger kann auch eine Transportvorrichtung verwendet werden. Hierbei wird die gesamte Transportvorrichtung relativ zu dem Vorsprung bewegt.

Durch die Erfindung wird auch ein Verfahren zum Verwenden der erfindungsgemäßen Klemmeinrichtung geschaffen. Hierbei wird zunächst die Dicke der zu klemmenden Leiterplatte eingelesen. Bei einer Mehrzahl von zu klemmenden Leiterplatten gleicher Dicke kann das Einlesen als einmaliger Schritt zu Anfang einer Mehrzahl von Klemmvorgängen durchgeführt werden.

Beispielsweise wird mittels des Trägers der Klemmvorrichtung und des Wegaufnehmers durch Klemmen einer Leiterplatte zwischen dem Vorsprung und dem Träger die Dicke der Leiterplatte ermittelt. Der Wert der Dicke kann beispielsweise in einem Speicher der Regelvorrichtung abgespeichert werden. Bei dem erfindungsgemäßen Verfahren kann dieser Wert auch eingelesen werden, z.B. aus einem externen Speicher. Auch manuelle Eingaben des der Dicke der Leiterplatte entsprechenden Wertes sind möglich.

Anschließend wird der Träger mittels des regelbaren Antriebs auf den Vorsprung zu bewegt. Währenddessen wird der Abstand des Trägers von dem Vorsprung mittels des Wegaufnehmers überwacht. Wird ein der Dicke entsprechender Abstand des Trägers von dem Vorsprung erfasst, wird der Antrieb gestoppt und dadurch der Träger angehalten. Dies ermöglicht ein schnelles und sicheres Klemmen der zu klemmenden Leiterplatte.

Um eine noch größere Sicherheit beim Klemmen der Leiterplatte zu erreichen, ist es möglich, nach dem Regeln des Abstands zwischen dem Träger und dem Vorsprung, den Träger mittels des Antriebs weiter auf den Vorsprung zu anzutreiben und dabei mittels des Wegaufnehmers den Abstand zwischen dem Träger und dem Vorsprung zu überwachen. Dies wird solange durchgeführt, bis sich der Abstand zwischen dem Vorsprung und dem Träger nicht mehr verringert, bzw. keine Verringerung des Abstands mehr erfasst wird.

Daraufhin kann für eine vorbestimmte Zeitdauer gewartet werden. Anschließend wird ein Freigabesignal für eine Bearbeitungsvorrichtung ausgegeben, mittels welcher die Leiterplatte weiter verarbeitet werden kann. Hierbei bietet die aktive Überwachung des Abstands zwischen dem Träger und dem Vorsprung gemäß der Erfindung den Vorteil, dass das Freigabesignal an die Bearbeitungsvorrichtung innerhalb einer sehr geringen Zeitspanne erfolgen kann. Erfindungsgemäß wird nämlich unmittelbar nachdem die Leiterplatte mittels des Trägers zwischen dem Vorsprung und der Leiterplatte geklemmt worden ist, erfasst, dass die Leiterplatte geklemmt ist. Daher kann ein entsprechendes Freigabesignal sehr schnell ausgegeben werden.

Die herkömmlicherweise erforderliche relativ lange Wartezeit, um sichergehen zu können, dass die Leiterplatte geklemmt wurde, kann deutlich reduziert werden oder sogar ganz entfallen. Gleichzeitig ist die Sicherheit beim Klemmen verbessert.

Die Erfindung wird unter Bezugnahme auf die Zeichnung näher erläutert. In der Zeichnung zeigen:
Figur 1 einen schematischen Schnitt einer bevorzugten Ausführungsform der erfindungsgemäßen Klemmeinrichtung, und
Figur 2 eine schematische Seitenansicht der bevorzugten Ausführungsform.

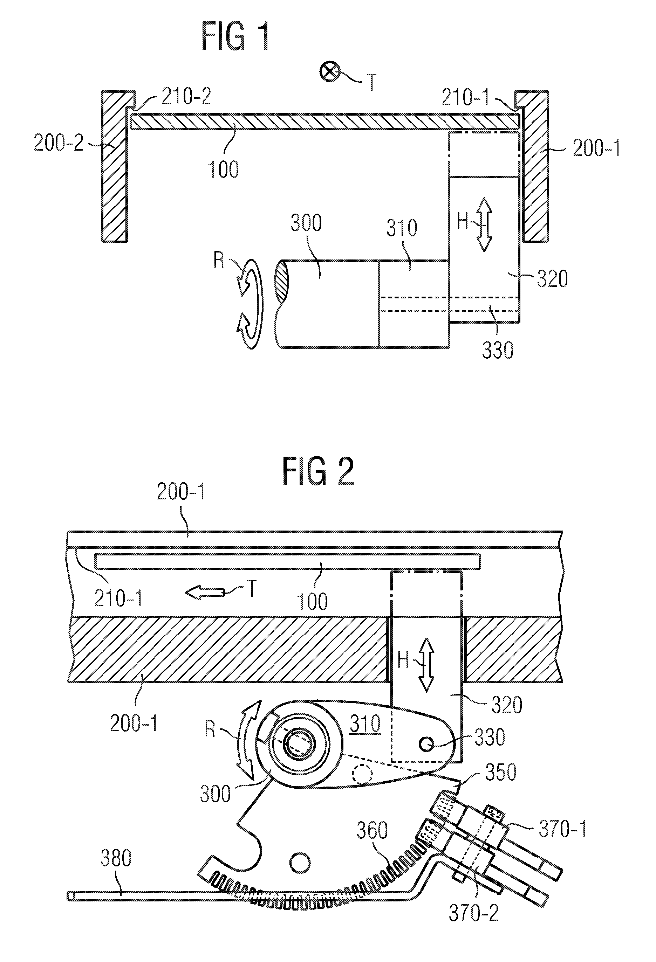

Aus Figur 1 ist eine Leiterplatte 100 ersichtlich, welche in einer Transportrichtung T mittels einer Transportvorrichtung (nicht gezeigt) transportierbar ist. Die Leiterplatte 100 ist zwischen zwei Seitenführungen 200-1 und 200-2 geführt, welche sich entlang der Transportrichtung T erstrecken. An den Seitenführungen 200-1 und 200-2 ist jeweils ein Vorsprung 210-1 bzw. 210-2 ausgebildet. Der Vorsprung ist parallel zu der Transportrichtung T über der zu klemmenden Leiterplatte 100 ausgebildet und erstreckt sich entlang der Transportrichtung.

Mittels eines Trägers 320, welcher auf den Vorsprung 210-1 zu bewegt werden kann, ist es möglich, die Leiterplatte 100 zwischen dem Vorsprung 210-1 und dem Träger 320 zu klemmen. Der Träger 320 wird dazu über eine Welle 300 angetrieben. An der Welle 300 ist ein Exzenter 310 vorgesehen, welcher über ein Gelenk 330 mit dem Träger 320 verbunden ist. Eine Drehbewegung der Welle 300 in Richtung R kann dadurch in eine Hubbewegung des Trägers 320 in Richtung H umgesetzt werden.

Figur 2 zeigt die bevorzugte Ausführungsform der Erfindung aus Figur 1 in schematischer Seitenansicht. Zusätzlich zu Figur 1 ist ein Wegaufnehmer ersichtlich. Der Wegaufnehmer ist als Winkelaufnehmer ausgebildet und weist einen Inkrementalgeber 350 auf, welcher an der Welle 300 angebracht ist.

Der Inkrementalgeber 350 ist scheibensegmentförmig ausgebildet und weist entlang seines Umfangsbereichs eine Mehrzahl von Inkrement-Elementen 360 auf. Die Inkrement-Elemente 360, z.B. feine Schlitze in dem Umfangsbereich des Inkrementalgebers 350, werden mittels zweier Lichtschranken 370-1 und 370-2 abgetastet, deren Strahlengang sie zumindest zeitweise unterbrechen. An einem Träger 380 sind die Lichtschranken 370-1 und 370-2 befestigt und entsprechend zu den Inkrement-Elementen 360 ausgerichtet.

Mittels des Wegaufnehmers ist es daher möglich, die Stecke zu bestimmen, welche der Träger 320 in der Richtung H zurücklegt. Hierdurch kann nach dem erfindungsgemäßen Verfahren der Abstand zwischen dem Träger 320 und dem Vorsprung 210-1 exakt entsprechend der Dicke der Leiterplatte 100 eingestellt werden.

Es ist auch möglich, die Leiterplatte 100 zusammen mit einem sie tragenden Transportband (nicht gezeigt) durch den Träger 320 an dem Vorsprung 210-1 zu klemmen. Dies bietet den Vorteil dass das zum Transportieren der Leiterplatte 110 verwendete Transportband an jener Stelle, an welcher die Leiterplatte 100 geklemmt werden soll, nicht unterbrochen oder umgelenkt werden muss, um die Klemmung durchführen zu können. Es ist jedoch auch möglich, den Träger 320 seitlich an dem Transportband vorbei zu führen, um die Klemmung durchführen zu können oder den Träger 320 an einer Stelle anzuordnen, an welcher das Transportband ohnehin unterbrochen ist bzw. kein Transportband erforderlich ist.

Anders als in der Darstellung nach Figur 1 gezeigt, ist es auch möglich, beide den Seitenführungen 200-1 und 200-2 zugewandten Seiten der Leiterplatte 100 mit jeweils einem separaten Träger zu klemmen. Hierzu ist beispielsweise symmetrisch dem an der Seitenführung 210-1 angeordneten Träger 320 ein entsprechender Träger auch an der Seitenführung 200-2 angeordnet. Die beiden Träger können separat angetrieben sein. Es ist auch möglich, für jeden Träger einen separaten Wegaufnehmer vorzusehen.

Der Träger kann flächig ausgebildet sein und im wesentlichen den Abmessungen der durch die Länge und Breite der Leiterplatte bestimmten Bestückfläche entsprechen.

Ferner ist es möglich, auf dem Träger speziell gestaltete Kontaktstücke anzuordnen, welche der Oberfläche der zu klemmenden Leiterplatte jedenfalls in dem Bereich angepasst sind, in welchem die Oberfläche zum Klemmen mit dem Träger berührt wird. Dies ist beispielsweise günstig, falls die Unterseite der Leiterplatte bereits mit Bauelementen oder anderen Körpern versehen ist. Durch die Kontaktstücke kann ein Beschädigen der Oberfläche der zu klemmenden Leiterplatten und/oder der darauf angeordneten Bauelemente vermieden werden.

Anstatt des Abstands zwischen dem Träger und dem Vorsprung kann auch der Abstand zwischen der Leiterplatte und dem Vorsprung überwacht werden.

## Patentansprüche

1. Klemmeinrichtung für Leiterplatten (100) mit relativ zu deren Länge und Breite geringer Dicke, wobei die Leiterplatten eine durch die Länge und Breite bestimmte Bestückfläche aufweisen, die Klemmeinrichtung mit
• einem Träger (320), auf welchem die Leiterplatten (100) parallel zu ihrer Bestückfläche angeordnet sind,
• einer seitlich des Trägers (320) angeordneten Seitenführung (200-1, 200-2), von welcher die Leiterplatten (100) entlang einer Transportrichtung (T) geführt sind, und
• einem an der Seitenführung (200-1, 200-2) ausgebildeten Vorsprung (210-1), der sich an dem dem Träger (320) abgewandten Endbereich der Seitenführung (200-1) parallel zu der Bestückfläche der Leiterplatten (100) in der Transportrichtung (T) über den Leiterplatten (100) erstreckt, **dadurch gekennzeichnet, dass**
• der Träger (320) mit einem regelbaren Antrieb gekoppelt ist, mittels welchem der Träger (320) derart zu dem Vorsprung (210-1) bewegbar ist, dass die Leiterplatte (100) zwischen dem Träger (320) und dem Vorsprung (210-1) festlegbar ist,
• ein Wegaufnehmer vorgesehen ist, von welchem der Abstand des Trägers (320) von dem Vorsprung (210-1) erfassbar ist, und
• eine Regelvorrichtung vorgesehen ist, welche mit dem Wegaufnehmer gekoppelt ist und von welcher der Antrieb steuerbar ist, wobei der Regelvorrichtung als Führungsgröße die Dicke der Leiterplatte (100) und als Regelgröße der Abstand des Trägers (320) von dem Vorsprung (210-1) zuführbar sind, und wobei von der Regelvorrichtung aufgrund der zugeführten Führungsgröße und der stetig zugeführten Regelgröße der Abstand des Trägers (320) von dem Vorsprung (210-1) durch Steuern des Antriebs entsprechend der Dicke der Leiterplatte (100) regelbar ist.

2. Klemmeinrichtung nach Anspruch 1, **dadurch gekennzeichnet, dass**
• von der Regelvorrichtung mittels des Wegaufnehmers nach dem Regeln des Abstands zwischen dem Träger (320) und dem Vorsprung (210-1) der Antrieb zum Verringern des Abstands steuerbar ist, und
• überwachbar ist, ob sich der Abstand zwischen dem Vorsprung (210-1) und dem Träger (320) verringert.

3. Klemmeinrichtung nach Anspruch 2, **dadurch gekennzeichnet, dass**
• von der Regelvorrichtung ein Freigabesignal an eine Bearbeitungsvorrichtung ausgebbar ist, nachdem für eine vorbestimmte Zeitdauer keine Verringerung des Abstands erfaßt worden ist.

4. Klemmeinrichtung nach einem der Ansprüche 1 bis 3, **dadurch gekennzeichnet, dass**
• der Wegaufnehmer ein optischer Aufnehmer, ein induktiver Aufnehmer, ein magnetischer Aufnehmer, ein resistiver Aufnehmer oder ein inkrementaler Aufnehmer ist.

5. Klemmeinrichtung nach Anspruch 1 bis 4, **dadurch gekennzeichnet, dass**
• der Träger (320) an einem mit einer Welle (300) verbundenen Exzenter (310) gelagert und durch Drehen der Welle (300) linear bewegbar ist, und
• der Wegaufnehmer ein an der Welle angeordneter Winkelaufnehmer (350, 360, 370-1, 370-2) ist.

6. Klemmeinrichtung nach Anspruch 1 bis 5, **dadurch gekennzeichnet, dass**
• die Leiterplatten (100) auf einem Transportband angeordnet sind, und
• der Träger (320) an dem Transportband anlegbar ist, um die Leiterplatte (100) an dem Vorsprung (210-1) zu klemmen.

7. Klemmeinrichtung nach Anspruch 1 bis 5, **dadurch gekennzeichnet, dass**
• der Träger (320) eine Transportvorrichtung ist.

8. Verfahren zum Verwenden der Klemmeinrichtung nach Anspruch 1 bis 7, mit folgenden Schritten:
• Einlesen der Dicke einer zu klemmenden Leiterplatte (100),
• Antreiben eines Trägers (320) auf den Vorsprung (210-1) zu unter Überwachen des Abstands mittels eines Wegaufnehmers, und
• Anhalten des Trägers (320) bei einem der Dicke entsprechenden Abstand von dem Vorsprung (210-1).

9. Verfahren nach Anspruch 8, mit folgenden, auf das Anhalten des Trägers folgenden Schritten:
• Antreiben des Trägers (320) auf den Vorsprung (210-1) zu unter Überwachen des Abstands zwischen dem Träger (320) und dem Vorsprung (210-1) mittels des Wegaufnehmers,
• Warten bis sich der Abstand nicht mehr verringert, und Ausgeben eines Freigabesignals an eine Bearbeitungsvorrichtung, nachdem sich der Abstand für eine vorbestimmte Zeitdauer nicht mehr verringert hat.
